# EUROPÄISCHE PATENTANMELDUNG

(11) **EP 4 509 876 A1**
(43) Veröffentlichungstag der Anmeldung: **19.02.2025**
(21) Anmeldenummer: 24194406.5
(22) Anmeldetag: 13.08.2024
(51) Int. Cl.: G01S 15/88, E05B 81/64, G01S 7/539, G01S 7/52

(54) **ULTRASCHALL-NÄHERUNGSSCHALTER**

(30) Priorität: 17.08.2023 CH 2308742023
(71) Anmelder: ELESTA GmbH Ostfildern (DE) Zweigniederlassung, 7310 Bad Ragaz SG (CH)
(72) Erfinder: Piai, Guido, 9473 Gams (CH); Frick, Klaus, 6822 Satteins (AT); Möhr, Raphael, 7304 Maienfeld (CH)
(74) Vertreter: Swisspat Riederer Hasler Patentanwälte AG

(57) **Zusammenfassung**

Dargestellt und beschrieben ist eine Vorrichtung und ein Verfahren zur Erkennung eines Betätigers durch Beschallen des Betätigers mit Schallwellen durch einen Sensor. Die Vorrichtung findet insbesondere in einer Sicherheitsanwendung Verwendung. Sensor und Betätiger sind relativ zueinander bewegbar. Der Sensor umfasst einen Schallwellensender, einen Schallwellenempfänger und eine Recheneinheit. Der Schallwellensender ist vorgesehen, Schallwellen in Richtung des Betätigers zu senden. Der Schallwellenempfänger wiederum ist ausgelegt, die vom Betätiger reflektierten Schallwellen aufzunehmen und in ein analoges Signal umzuwandeln. Die Recheneinheit wandelt das analoge Signal in ein digitales Signal um und realisiert die Erkennung des Betätigers durch Abgleich mit einem Referenz-Signal.

## Beschreibung

### TECHNISCHES GEBIET DER ERFINDUNG

Die Erfindung betrifft eine Vorrichtung zur Erkennung eines Betätigers durch einen Sensor gemäss Oberbegriff des Anspruchs 1 und ein Verfahren zur Erkennung eines Betätigers mit Hilfe von Schallwellen gemäss Anspruch 18.

### HINTERGRUND DER ERFINDUNG

Ultraschallsensoren kommen heutzutage zum Beispiel beim Vermessen von Distanzen zum Einsatz. Die Ultraschallwellen werden von der Sendequelle emittiert, stossen auf ein Hindernis, reflektieren ein Echo in Form von Ultraschallwellen in Richtung des Sensors zurück, in welchem sie durch den mindestens einen Empfänger aufgenommen werden. Mit Hilfe der gemessenen Zeit zwischen dem Versenden und Empfangen der Ultraschallwellen wird die Distanz zwischen dem Sensor und dem Hindernis bestimmt. Die somit von den Ultraschallsensoren zur Verfügung gestellte Information beschränkt sich darauf, ob ein Objekt vorhanden ist oder nicht und welche Distanz diese Objekt vom Ultraschallsensor hat. Um die Qualität der Messung zu erhöhen, können die Ultraschallsensoren mehrere Sendequellen und mehrere Empfänger aufweisen.

In Sicherheitsanwendungen finden Ultraschall-Sensoren heutzutage wenig bis keine Verwendung. Ein Nachteil der Ultraschall-Sensoren ist, dass sie auf die reflektierten Schallwellen bzw. das Echo angewiesen sind und dieses empfindlich auf äussere Einflüsse, wie z.B. Temperatur, reagiert. Ein weiterer Nachteil ist die erhöhte Komplexität des Systems zur Detektion von kleinen dreidimensionalen Strukturen.

Die chinesische Patentanmeldung CN 114758367 offenbart eine Fingerabdruck-Identifizierungsvorrichtung, die unter einer Druckplatte angeordnet ist. Die Identifizierungsvorrichtung umfasst eine Ultraschalleinheit, eine piezoelektrische Schicht, eine erste Elektrode, die sich oberhalb der piezoelektrischen Schicht befindet, und eine zweite Elektrode, die sich unterhalb der piezoelektrischen Schicht befindet. Die Ultraschalleinheit wird zum Senden von Ultraschallsignalen an einen Finger und zum Empfangen des vom Finger zurückgesendeten Ultraschallerkennungssignals verwendet. Unter der Ultraschalleinheit befindet sich ein Silizium-Substrat einer Dicke von ca. 50 µm mit einer Schalteinheit, die dazu dient, das Ultraschallsignal zu erzeugen und das Ultraschalldetektionssignal zu verarbeiten. Auf dem Silizium-Substrat ist eine piezoelektrische Schicht einer Dicke zwischen 4 und 20 Mikrometer aufgebracht, was eine Resonanzfrequenz zwischen 8 und 26 MHz erzeugt. Vorteilhaft ist zwischen der Ultraschalleinheit und der Druckplatte einer Verbindungsschicht vorgesehen.

Bei der Fingerabdruckidentifikation erzeugt die Schaltungseinheit ein Anregungssignal und bringt die piezoelektrische Schicht dadurch zum Vibrieren. Das dadurch erzeugte Ultraschallsignal wird an den Finger übertragen und reflektiert. Basierend auf dem inversen piezoelektrischen Effekt wird eine Potentialdifferenz zwischen der ersten Elektrode 112 und der zweiten Elektrode 113 erzeugt, um ein entsprechendes elektrisches Signal zu erhalten. Dieses wird verarbeitet, um das Fingerabdruckmuster des Fingers zu erhalten.

GB2529484 offenbart eine Analysevorrichtung mit einen Eingang zum Empfangen von Ultraschalldaten in Bezug auf eine Kontaktoberfläche zwischen ersten und zweiten Elementen in tribologischem Kontakt und einen Ausgang zum Ausgeben von Daten in Bezug auf mindestens eine Kontaktspannung im ersten Element oder eine auf das erste Element ausgeübte Kontaktlast. In einem Verarbeitungsabschnitt werden die Ultraschalldaten verarbeitet, um Ultraschall-Laufzeitdaten zu bestimmen, und die Ausgabedaten abzuleiten. Senkrecht zur Kontaktoberfläche hat die Ausbreitungsrichtung des Ultraschalls eine größte Komponente. Die Verarbeitung zum Bestimmen von Ultraschall-Laufzeitdaten und das Bestimmen der Ultraschall-Flugzeit erfolgt unabhängig von einer Phasenverschiebung, die von einer Kontaktbedingung an der Kontaktoberfläche abhängt.

### AUFGABE

Es ist deshalb eine Aufgabe der vorliegenden Erfindung, eine Vorrichtung zur Erkennung eines Betätigers mit Hilfe von Schallwellen zu zeigen, welche sowohl in der Herstellung als auch im Einsatz kostengünstig ist und gegen die Empfindlichkeit der Schallwellensensoren auf äussere Einflüsse und auf Veränderungen der zu detektierenden Betätiger robust ist.

### BESCHREIBUNG

Die Aufgabe wird gelöst mit einer Vorrichtung zur Erkennung eines Betätigers durch Beschallen des Betätigers mit Schallwellen durch einen Sensor mit den Merkmalen des Patentanspruchs 1.

Die Vorrichtung findet insbesondere als Ultraschall-Näherungsschalter in einer Sicherheitsanwendung Verwendung. Der Sensor ist relativ zum Betätiger bewegbar und umfasst zumindest einen Schallwellensender, zumindest einen Schallwellenempfänger und zumindest eine Recheneinheit. Der Schallwellensender ist vorgesehen, Schallwellen in Richtung des Betätigers zu senden. Der Schallwellenempfänger wiederum ist vorgesehen, die vom Betätiger reflektierten Schallwellen aufzunehmen und in ein analoges Signal umzuwandeln. Die Recheneinheit wandelt das analoge Signal in ein digitales Signal um und realisiert die Erkennung des Betätigers durch Abgleich mit einem Referenz-Signal.

Die Recheneinheit verfügt über ein in einem Speicher abgelegtes Referenz-Signal, welches in der Regel einem bestimmten Betätiger zugeordnet ist. Der Sensor ist vorgesehen, Schallwellen zu emittieren und die reflektierten Schallwellen wiederum zu empfangen. Durch das Abgleichen der reflektierten Schallwellen mit dem bereits in der Recheneinheit abgelegten Referenz-Signal kann die Recheneinheit feststellen, ob die Schallwellen von dem Betätiger reflektiert worden sind, der dem Referenz-Signal zugehörig ist. Die Vorrichtung kann mit Hilfe des Sensors und des durch diesen empfangenen Signals den beschallten Betätiger erkennen und gegebenenfalls identifizieren. Die Vorrichtung ermöglicht festzustellen, ob sich der Betätiger an einer gewissen Position gegenüber dem Sensor befindet. Der Betätiger kann hierfür sowohl am Sensor anliegen als auch vom Sensor in einem gewissen Abstand entfernt sein. Beim Einsatz in einer Sicherheitsanwendung hat das Zusammenspiel zwischen Sensor und Betätiger eine sicherheitsrelevante Funktion. Die erfolgreiche Erkennung des Betätigers, so dass der Sensor mit Hilfe der Recheneinheit bestimmen kann, ob der eingelernte Betätiger am vorgesehen Ort ist oder nicht, kann mit der Gewährleistung der Sicherheit einer Anlage gleichgesetzt werden. Zum Beispiel kann der Schliesszustand einer Türe oder eines Fensters mit Hilfe dieser Vorrichtung beobachtet werden. Der Betätiger kann in der Türe oder im Fenster angeordnet sein während der Sensor im Rahmen platziert ist, oder auch umgekehrt. Lediglich wenn die Türe oder das Fenster vollständig geschlossen sind und der Abstand zwischen der Türe oder dem Fenster zum Rahmen minimal ist, findet eine positive Erkennung des Betätigers statt, was wiederum mit dem geschlossenen Zustand der Türe oder des Fensters gleichgesetzt ist.

Das Referenz-Signal enthält die Information zur Erkennung eines Betätigers. Die Anforderung an das Referenz-Signal ist, dass es einen Abgleich mit dem gemessenen Signal ermöglichen muss. Das Referenz-Signal kann in beliebiger Form in der Recheneinheit abgelegt sein, womit die Art oder Form des Referenz-Signals keine einschränkende Wirkung auf den Erfindungsgegenstand hat. Vorstellbar ist, dass das Referenz-Signal in Form einer zeitlichen Funktion, einer Tabelle oder eines Diagramms vorliegt, wobei es sich hierbei um eine nicht abschliessende Liste von Wiedergabemöglichkeiten von Daten handelt. Im Referenz-Signal muss zweckmässigerweise mindestens die Korrelation zwischen Zeit und Amplitude enthalten sein.

Das abgelegte Referenzsignal oder eine, beziehungsweise mehrere Kopien davon, können an die ändernden Umgebungsbedingungen angepasst werden. Dazu könnte eine Kopie des Referenzsignals beim erkannten, identifizierten und anliegenden Betätiger in zeitlich vorgegebenen Intervallen oder anhand anderer Kriterien erneuert werden.

Beim erneuten Abgleich der reflektierten Schallwellen werden dann sowohl das ursprüngliche wie auch die erneuerten Referenz-Signale hergenommen.

Vorzugsweise weist der Betätiger ein dreidimensionales Muster auf, von welchem die Schallwellen reflektiert und verändert werden. Damit wird ermöglicht, unterschiedliche Betätiger mit einem ähnlichen Aufbau zu realisieren, wobei sie sich lediglich durch das dreidimensionale Muster voneinander differenzieren. Zugleich hilft das dreidimensionale Muster, die Identifikation eines Betätigers zuverlässiger festzustellen, indem das erste dreidimensionale Muster eine klare Abweichung zu den dreidimensionalen Mustern der anderen Betätigern erkennen lässt, was wiederum die Zuverlässigkeit und den Manipulationsschutz der Erkennung des Betätigers erhöht.

Der Sensor umfasst bevorzugt zwei Recheneinheiten, welche jeweils Zugriff auf ein Referenz-Signal haben. Grundsätzlich können diese die Umwandlung in ein digitales Signal selbstständig vornehmen, oder es kann auch nur ein Analog-Digital-Wandler vorgesehen sein. Die Verwendung von zwei Recheneinheiten kann als Kontrolle dienen, indem weitere Schritte lediglich dann vorgenommen werden, wenn beide Recheneinheiten das gleiche Ergebnis bezüglich der Übereinstimmung des gemessenen Signals mit dem Referenz-Signal anzeigen. Die Umwandlung durch die zwei Recheneinheiten kann auch voneinander unabhängig auf unterschiedliche Art durchgeführt werden mit z.B. von der Technologie her unterschiedlichen Analog/Digital-Wandlern (A/D-Wandler), integriert im Mikrocontroller (MCU) oder extern als dedizierter Baustein. Auch mit der Abtastfrequenz können Unterschiede erzielt werden. Dies erhöht die Sicherheit der Umwandlungsfunktion in ein digitales Signal im Betrieb.

Die vom Sensor emittierten Schallwellen gelangen über die Vorlaufstrecke zum dreidimensionalen Muster und legen die gleiche Strecke nach der Reflexion am Muster wieder in die entgegengesetzte Richtung zurück. Die Vorlaufstrecke zwischen dem Sensor und dem Muster weist eine auf den Sensor abgestimmte Mindestlänge auf. Die untere Grenze der Vorlaufstrecke dient zur Sicherstellung, dass nach dem Emittieren von Schallwellen durch den Sensor eine gewisse Zeit vergeht, bis die reflektierten Wellen durch den Empfänger empfangen werden. Die Zeitdauer weist ebenfalls eine untere Grenze auf, die nicht unterboten werden darf, wenn der Sender und der Empfänger durch das gleiche Bauelement gebildet sind. In einer solchen Ausführungsform wird die Membran, mit der die Schallwellen erzeugt werden, auch zum Empfangen der reflektierten Wellenverwendet. Die minimale Zeit ist dabei durch die Zeitdauer definiert, die die Membran braucht, um nach einer Anregung wieder in den Ruhezustand zu gelangen.

Der Betätiger weist vorzugsweise eine Kontaktfläche für den Sensor auf, wobei das dreidimensionale Muster im Betätiger und im Abstand zur Kontaktfläche angeordnet ist. Das Muster (Codierung) hat zur Kontaktfläche mindestens den Abstand der der Vorlaufstrecke entspricht. Der Betätiger kann vorgesehen sein, mit dem Sensor einen Kontakt herzustellen. Dieser Kontakt sollte vorzugsweise über die Kontaktfläche des Betätigers erfolgen. Dies ermöglicht eine günstige Einführung der Schallwellen vom Sensor in den Betätiger und vom Betätiger wieder zurück in den Sensor. Der Ultraschallwandler des Sensors kontaktiert den Betätiger vorzugsweise an der vorgesehenen Kontaktfläche. Das Muster des Betätigers liegt dann nach der Vorlaufstrecke im Innern des Betätigers - also so gesehen gegenüber der oder im Abstand zur Kontaktfläche. Durch das Anordnen des dreidimensionalen Musters gegenüberliegend der Kontaktfläche ist die Distanz zwischen dem Muster und der Kontaktfläche möglichst gross gewählt.

In einer bevorzugten Ausführungsform der Vorrichtung ist der Betätiger gegenüber dem Sensor derart angeordnet, dass bei Kontakt zwischen dem Betätiger und dem Sensor, oder wenn der Sensor und der Betätiger den minimal erforderlichen Abstand voneinander einnehmen, der Schallwellensender des Sensors auf das Muster des Betätigers gerichtet ist. Der Sensor dient zur Erkennung des Betätigers und dessen dreidimensionalen Musters. In bestimmten Anwendungen kann es ausreichend sein, wenn die Erkennung des Betätigers nur realisiert wird, wenn der Sensor mit dem Betätiger in Kontakt ist oder die Distanz zwischen dem Sensor und dem Betätiger minimal ist. Dies reduziert das Fenster, in welchem die Erkennung des Betätigers durch den Sensor möglich ist und führt dadurch zu einer höheren Sicherheitshürde bei Verwendung der Vorrichtung in einer Sicherheitsanwendung. Die Erkennung des Betätigers gelingt zweckmässigerweise lediglich, wenn der Sensor und der Betätiger die kleinstmögliche Distanz zueinander aufweisen.

In einer weiteren bevorzugten Ausführungsform müssen der Schallwellensender und der Schallwellenempfänger zur Erkennung des Betätigers an der Kontaktfläche des Betätigers anliegen. Das heisst, der Sensor muss in Kontakt mit dem Betätiger sein, um eine erfolgreiche Erkennung des Betätigers vornehmen zu können. In der Anwendung ermöglicht dieses Merkmal die Sicherstellung einer spaltenfrei geschlossenen Türe. Sobald die Türe einen kleinen Spalt offen ist und dadurch zum Beispiel die Sicherheit einer Anlage nicht mehr gewährleistet ist, kann dies durch den Sensor erfasst werden.

Der Schallwellenempfänger nimmt bevorzugt die reflektierte Schallwellen in ihrer Gesamtheit auf. In ihrer Gesamtheit aufgenommen bedeutet, dass der Schallwellenempfänger die reflektierten Schallwellen lokal an einer Stelle empfängt und diese in ein einziges Signal umwandelt. Damit kann die Vorrichtung mit nur einem Sensor funktionieren, was die Herstellung vereinfacht, den Platzbedarf reduziert und die Kosten minimiert.

Die Recheneinheit hat die Aufgabe, den Abgleich zwischen dem empfangenen Signal und dem Referenz-Signal zu erstellen. Die Bearbeitungsgeschwindigkeit der Recheneinheit zur Erstellung dieses Abgleichs ist am schnellsten, wenn die Recheneinheit einen möglichst direkten Zugriff auf das Referenz-Signal hat. Vorzugsweise ist das Referenz-Signal in der Recheneinheit abgelegt. Dies ermöglicht den direktesten Zugang der Recheneinheit zum Referenz-Signal. Eine schnelle Bearbeitungsgeschwindigkeit der Recheneinheit kann besonders bei Sicherheitsanwendungen von grosser Bedeutung sein.

Das Muster des Betätigers weist idealerweise eine dreidimensionale Struktur auf. Eine dreidimensionale Struktur bringt den Vorteil mit sich, dass die Schallwellen bei der Reflexion eine markante Veränderung erfahren, was den Rückschluss von den reflektierten Schallwellen auf den Betätiger erleichtert. Zugleich bietet eine dreidimensionale Struktur eine grössere Vielfalt an Modifikationsmöglichkeiten zum Erstellen von unterschiedlichen dreidimensionalen Mustern.

In einer weiteren bevorzugten Ausführungsform umfasst das Muster zwei der Kontaktfläche des Betätigers zugewandte Flächen, welche je eine unterschiedliche Distanz zur Kontaktfläche aufweisen. Die Unterteilung des Musters in zwei Flächen, welche jeweils eine unterschiedliche Distanz zur Kontaktfläche aufweisen, bildet eine dreidimensionale Struktur. Zugleich bildet die Unterteilung in zwei Flächen mit unterschiedlichen Distanzen zur Kontaktfläche eine einfache Konstruktion mit einer grossen Anzahl Variationsmöglichkeiten, indem die Distanz zur Kontaktfläche einer der Flächen oder beider Flächen verändert wird.

Wie bereits oben erwähnt, werden die reflektierten Schallwellen vorzugsweise in ihrer Gesamtheit empfangen und ausgewertet, welche von den zwei Flächen des Musters reflektiert werden. Die Auswertung der Schallwellen in ihrer Gesamtheit bringt auch Vorteile bei der Gestaltung des Musters mit sich. So kann die Differenz des Abstandes der zwei Flächen zur Kontaktfläche sehr gering sein. Vorzugsweise ist die Differenz zwischen den Distanzen dieser zwei Flächen weniger als 1 mm, bevorzugt weniger als 0.5 mm, noch bevorzugter weniger als 0.3 mm, jedoch mehr als 0.01 mm und vorzugsweise mehr als 0.05 mm.

Vorteilhafterweise erkennt die Recheneinheit durch Abgleich mit einem Referenz-Signal das Muster des Betätigers. Die Recheneinheit ist für das Erstellen eines Abgleichs zwischen dem gemessenen Signal mit dem Referenz-Signal zuständig.

Die Recheneinheit ist für die Erkennung des Betätigers zuständig. Vorzugsweise erzeugt die Recheneinheit ein binäres Signal aufgrund der Erkennung des Betätigers. Das binäre Signal erlaubt eine Aussage, ob zum Beispiel der Betätiger am Sender/Empfänger anliegt oder nicht. Dies kann für sicherheitsrelevante Anwendungen wiederum von grosser Bedeutung sein, da damit eine Aussage durch die Vorrichtung getätigt wird, welche einen eindeutigen Zustand der Vorrichtung beschreibt. Zum Beispiel kann ein solcher Zustand eine geschlossene Sicherheitstüre sein.

In einer weiteren bevorzugten Ausführung erzeugt die Recheneinheit ein Abschalt-Signal bei nicht erfolgreicher Erkennung des Betätigers. Das Erzeugen eines Abschalt-Signals ist in der Regel bei Sicherheitsanwendungen von sehr grosser Bedeutung. Das Erkennen des Betätiger bildet den Grundzustand, in welchem die Sicherheit gewährleistet ist. Solange der Betätiger erkannt wird, ist die Sicherheit der Anlage gewährleistet. Dem Wunsch, eine Gefahrenlage so schnell wie möglich zu detektieren und an eine Steuereinheit weiterzuleiten, kann nachgekommen werden, indem das Abschalt-Signal so schnell wie möglich erzeugt wird. Das Erzeugen eines Abschalt-Signals durch die Recheneinheit führt zu einer sehr schnellen Reaktion auf etwaige Änderungen bei der Zuordnung zwischen dem Sender und dem Betätiger.

Idealerweise sind der Schallwellensender und der Schallwellenempfänger am gleichen Ort angeordnet, insbesondere verwenden sie die gleiche Membran zum Versenden und Empfangen von Schallwellen. Somit fällt der Ausgangspunkt der Schalwellen mit dem Empfangspunkt der reflektierten Schallwellen zusammen. In der Regel werden die reflektierten Schallwellen aus jener Richtung empfangen, in welche die Schallwellen emittiert werden. Durch Anordnen des Senders und Empfängers am gleichen Ort kann der Sensor einen kompakten Aufbau aufweisen. Falls darüber hinaus die gleiche Membran von Sender und Empfänger verwendet wird, kann auch ein Element wie ein Transducer eingesetzt sein, welcher einen Sender und einen Empfänger umfasst. Die Verwendung der gleichen Membran für den Sender und Empfänger führt zu tieferen Herstellungskosten des Sensors und somit der ganzen Vorrichtung. Vorzugsweise wird ein piezoelektrischer Ultraschallwandler eingesetzt, der sowohl als Sender als auch als Empfänger verwendbar ist.

Vorzugsweise erzeugt der Schallwellensender Schallwellen mit einer Frequenz von 300 kHz bis 20 MHz, vorzugsweise zwischen 350 kHz und 8 MHz, und besonders bevorzugt zwischen 1 und 4 MHz. In diesen Bereich fallen nur Ultraschallwellen. Die Verwendung dieses Frequenzbereichs verursacht keine ungewollte Belastung der Umgebung.

Der Betätiger ist vorzugsweise aus Kunststoff hergestellt. Bevorzugt wird ein Kunststoff mit niedriger und über die Temperatur konstanter Schallgeschwindigkeit, wie z.B. POM (Polyoxymethylen), verwendet. Vorzugsweise ist ein Kunststoff verwendet, in welchem Material die Schallausbreitung geringer als 2500 m/s und der Einfluss der Temperaturänderung geringer als 2 m/s pro Grad Celsius ist. Kunststoff bietet den Vorteil, dass er günstig in der Herstellung von komplexen Formen und Strukturen ist, wie sie zum Beispiel beim Muster des Betätigers vorkommen können. Zugleich verfügt Kunststoff über die notwendige Eigenschaft, die Schallwellen derart gut zu reflektieren, dass diese in ihrer Gesamtheit empfangen und ausgewertet werden können.

Ein weiterer Aspekt der Erfindung betrifft ein Verfahren zur Erkennung eines Betätigers mit Hilfe von Schallwellen. Die Schallwellen werden durch einen Schallwellensender ausgesendet und durch einen Schallwellenempfänger aufgenommen. Das Verfahren umfasst das Senden von Schallwellen auf ein Muster des Betätigers und das Empfangen der durch das Muster des Betätigers reflektierten Schallwellen durch den Schallwellenempfänger. Die empfangenen Schallwellen werden in ein elektrisches Signal umgewandelt. Weiter ist ein Abgleich dieses Signals durch die Recheneinheit mit einem darin abgelegten Referenz-Signal und das Erzeugen eines binären Signals als Ergebnis des Abgleichs durch die Recheneinheit und Bestimmen der Erkennung des Betätigers aufgrund des binären Signals im erfindungsgemässen Verfahren vorgesehen. Der Abgleich des gemessenen Signals mit dem Referenz-Signal erlaubt, die Übereinstimmung beider Signale zu bestimmen. Wenn die Übereinstimmung eine vordefinierte Ähnlichkeit zeigt, wird der beschallte Betätiger als eingelernter Referenz-Betätiger positiv erkannt. Somit kann zum Beispiel eine Aussage getroffen werden, ob der eingelernte (Referenz-) Betätiger am Sensor anliegt oder nicht. Vorteilhafterweise werden die reflektierten Schallwellen in ihrer Gesamtheit durch den Schalwellenempfänger aufgenommen. Damit ist gemeint, dass ein einzelner Schallwellenempfänger die reflektierten Schallwellen aufnimmt und aufgrund der reflektierten und empfangenen Schallwellen ein einzelnes Mess-Signal bildet. Dies ermöglicht, die Konstruktion des Sensor möglichst einfach zu gestalten, da der Sensor lediglich einen Schallwellensender und einen Schallwellenempfänger aufweisen muss.

Vorzugsweise wird in einem ersten Schritt das Referenz-Signal durch Einlernen des Betätigers erzeugt. Das Einlernen des Betätigers beschreibt die Durchführung einer Referenz-Messung. Hierfür wird der Betätiger an die Soll-Position platziert und mit Schallwellen durch den Sensor beschallt. Der Empfänger im Sensor nimmt die reflektierten Schallwellen auf und bildet aufgrund der gemessenen Schallwellen ein Signal, welches das Referenz-Signal bildet. Somit kann das Referenz-Signal als Abbildung des eingelernten Betätigers verstanden werden.

Das Verfahren wird bevorzugt in einer Sicherheitsanwendung eingesetzt, wobei bei nicht erfolgreicher Erkennung des Betätigers ein Warn- oder Abschaltsignal bzw. ein Sicherheitsentzug erzeugt wird. Die mit diesem Verfahren durchführbare Kontrolle, ob der Betätiger an dem dafür vorgesehen Ort ist oder nicht und ob es der eingelernte Betätiger ist oder nicht, bietet sich für den Einsatz in Sicherheitsanwendungen an. Der Zustand einer Türe oder eines Fensters kann mit einem solchen Verfahren zuverlässig überwacht und bei einem Öffnungsvorgang kann eine Warnung oder ein Abschaltsignal sofort erzeugt werden. Ein Vorteil in dieser Hinsicht ist auch die hohe Empfindlichkeit des erfindungsmässigen Verfahrens. Die reflektierten Schallwellen weichen sehr schnell vom Referenz-Signal ab, wenn zum Beispiel der Betätiger nur ein wenig, d.h. im Bereich zwischen 0.1 und 1 mm, versetzt zum ursprünglichen Zustand ist. Die hohe Empfindlichkeit des Verfahrens bringt eine kleine Toleranz für die zu kontrollierende Einrichtung mit, was wiederum zu einer genauen Prüfung oder Kontrolle der zu überwachenden Einrichtung führt.

Vorteilhafterweise weist der Betätiger eine Kontaktfläche auf und der Schallwellensender liegt zur Erkennung des Betätigers an dieser Kontaktfläche an. Wenn der Schallwellensender an der Kontaktfläche des Betätigers anliegt, breiten sich die Schallwellen lediglich im Gehäuse des Betätigers aus. Somit gibt es keine störenden Einflüsse aus der Umgebung auf die Schallwellen und deren Messung, wie zum Beispiel durch unterschiedliche Distanz zwischen Betätiger und Sensor oder durch den Zustand der Luft zwischen dem Betätiger und dem Sensor. Das Vorsehen einer Kontaktfläche ermöglicht störungsfreie Messungen, insofern der Kontakt zwischen Sensor und Betätiger einwandfrei gegeben ist.

Vorzugsweise sendet der Schallwellensender senkrecht zur Kontaktfläche gerichtete Schallwellen aus. Damit wird das Volumen des Betätigers am effizientesten ausgenutzt, was wiederum eine bessere Unterscheidung zwischen den reflektierten Schallwellen zulässt.

Genannte optionale Merkmale können in beliebiger Kombination verwirklicht werden, soweit sie sich nicht gegenseitig ausschliessen. Insbesondere dort wo bevorzugte Bereiche angegeben sind, ergeben sich weitere bevorzugte Bereiche aus Kombinationen der in den Bereichen genannten Minima und Maxima.

### KURZBESCHREIBUNG DER FIGUREN

Nachfolgend wird die Erfindung unter Bezugnahme auf die Figuren in schematischer Darstellung näher beschrieben. Es zeigen in nicht massstabsgetreuer, schematischer Darstellung:
- Figur 1:: ein Schnittbild durch eine erfindungsgemässe Vorrichtung mit einem Sensor umfassend einen Schallwellensensor und einen Schallwellenempfänger und einen Betätiger;
- Figur 2:: eine Seitenansicht eines Betätigers;
- Figur 3:: sechs Diagramme mit Vergleich von Mess-Signalen von sechs Betätigern zu einem Referenz-Signal; und
- Figur 4:: Diagramm mit einem Korrelations-Verlauf für verschiedene Betätiger.

### DETAILLIERTE BESCHREIBUNG DER FIGUREN

Im Folgenden stehen gleiche Bezugsziffern für gleiche oder funktionsgleiche Elemente (in unterschiedlichen Figuren). Ein zusätzlicher Apostroph kann zur Unterscheidung gleichartiger bzw. funktionsgleicher oder funktionsähnlicher Elemente in einer weiteren Ausführung dienen.

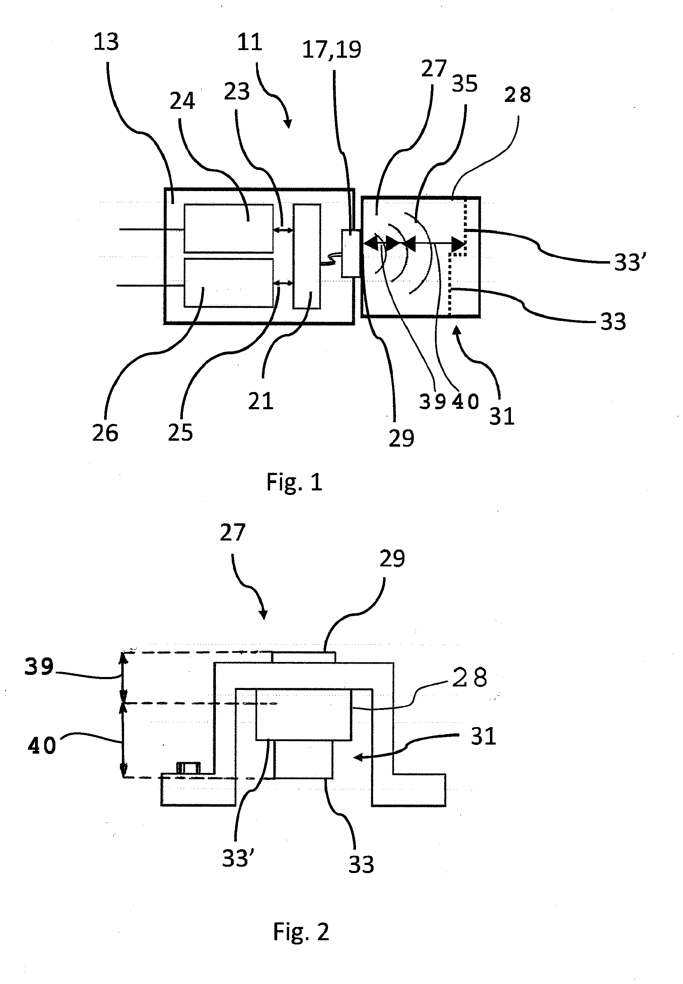

In Figur 1 ist eine Ansicht einer Vorrichtung 11 gezeigt, welche aus zwei separaten Bauteilen besteht. Das erste Bauteil ist ein Sensor 13. Der Sensor 13 umfasst einen Schallwellensender 17 und einen Schallwellenempfänger 19, welche mit einem analogen Frontend 21 verbunden sind. Vom analogen Frontend 21 führen zwei Kanäle 23,25 nach aussen. Die Kanäle 23,25 weisen je eine Recheneinheit 24,26 auf. Der Schallwellensender 17, kurz auch als Sender bezeichnet, und der Schallwellenempfänger 19, kurz auch als Empfänger bezeichnet, sind an einer vorderen Seite des Sensors 13 etwa an der gleichen Position angebracht. Der Sender und der Empfänger können auch dasselbe Bauelement sein, wobei in diesem Fall der Unterschied zwischen dem Sender und dem Empfänger lediglich in der Funktion des Sendens und Empfangens der Schallwellen zutage tritt. Vorzugsweise wird als Schallwellen-Wandler ein piezoelektrischer Sensor verwendet, der mit einer Frequenz zwischen 300 kHz und 20 MHz betrieben wird.

Das zweite Bauteil ist durch einen Betätiger 27 gebildet. In Figur 1 ist der Betätiger 27 mit dem Sender 17 und Empfänger 19 in Kontakt. Die Seite, mit welcher der Betätiger 27 mit dem Sender 17 und Empfänger 19 in Berührung steht, ist die Kontaktfläche 29 des Betätigers. An der Kontaktfläche 29 gegenüberliegenden Seite und in Abstand zu dieser ist im Betätiger 27 ein Muster 31 vorgesehen. Das Muster 31 ist im gezeigten Beispiel in Figur 1 durch eine Abstufung gebildet. Somit weist das Muster 31 zwei Flächen 33,33' auf, welche zur Kontaktfläche 29 hin zugewandt sind und zueinander und zur Kontaktfläche parallel sind. Die beiden Flächen 33,33' unterscheiden sich durch ihre Distanz zur Kontaktfläche 29. Der Unterschied kann zwischen 0.05 und 3 mm, vorzugsweise zwischen 0.1 und 2 mm, und besonders bevorzugt zwischen 0.5 und 1.5mm betragen.

Der Sender 17 ist vorgesehen, Schallwellen 35 in Richtung des Betätigers 27 zu emittieren. Falls der Betätiger 27 mit dem Sender 17 in Kontakt steht, breiten sich die vom Sender emittierten Schallwellen 35 im Betätiger bis zum Muster 31 aus. Das Muster 31 des Betätigers begrenzt die Ausbreitung der Schallwellen im Betätiger. Die Schallwellen 35 prallen auf das Muster 31 und werden von diesem reflektiert. Die reflektierten Schallwellen 35 wiederum legen den gleichen Weg in die entgegengesetzte Richtung zurück und gelangen zum Empfänger 19. Der Empfänger 19 weist eine Membran auf, welche durch die reflektierten Schallwellen in Schwingung versetzt wird. Die Schwingung der Membran des Empfängers wird als analoges Signal aufgezeichnet. In der analogen Empfangsschaltung (Front-End) 21 kann das analoge Signal weiterverarbeitet werden, indem es zum Beispiel verstärkt oder gefiltert wird. Nach der Verarbeitung im Frontend 21 wird das analoge Signal zu den jeweiligen Recheneinheiten 24,26 in den beiden Auswertekanälen 23, 25 weitergeleitet.

Die beiden Recheneinheiten 24,26 weisen je einen Speicher auf, in welchem je ein Referenz-Signalabgespeichert ist. Nach Empfang des elektrischen Signals vom Empfänger vergleicht jede Recheneinheit 24,26 dieses mit dem gespeicherten Referenz-Signal und bestimmt die Ähnlichkeit bzw. den Grad der Übereinstimmung beider Signale. Falls die Übereinstimmung einen gewissen Grad oder Wert übersteigt, bedeutet das, dass der zuvor eingelernte Betätiger 27 am Sensor anliegt.

Das Referenz-Signal kann auf unterschiedliche Art erzeugt werden. Eine Möglichkeit ist, dass vor Inbetriebnahme der Vorrichtung eine Referenzmessung zum Erzeugen des Referenz-Signals durchgeführt wird. Hierfür wird der Betätiger 27 an den Sensor geführt, so dass der Sender 17 und Empfänger 19 des Sensors auf der Kontaktfläche 29 des Betätigers zu liegen kommen. Die Beschallung des Betätigers 27 bewirkt ein Signal beim Empfänger 19, welches den Recheneinheiten 24,26 weitergeleitet und von diesen nach optionaler Signalverarbeitung jeweils als Referenz-Signal abgelegt wird. Somit wird mit dieser Referenzmessung der Betätiger 27 durch den Sensor 13 eingelesen.

In Figur 2 ist ein möglicher Aufbau eines Betätigers 27 gezeigt, welcher sich für die erfindungsgemässe Vorrichtung eignet. Gemäss dem gezeigten Ausführungsbeispiel umfasst der Betätiger ein Gehäuse 28, in welchem ein dreidimensionales Muster 33,33' integriert ist. Grundsätzlich möglich ist es aber auch, den Betätiger aus einem Vollmaterial herzustellen, in welchem das dreidimensionale Muster eingebettet ist. Vorliegend ist das Gehäuse des Betätigers als Zylinder mit einer abgestuften Bodenfläche 33,33' ausgebildet, wobei der Zylinder als Hohl- oder Vollzylinder ausgebildet sein kann.

Eine Seite des Betätigers dient als Kontaktfläche 29. Die der Kontaktfläche 29 gegenüberliegende Seite dient als Muster 31. Die Distanz zwischen der Kontaktfläche 29 und dem Muster 31 ist in zwei Strecken geteilt, eine sogenannte Vorlaufstrecke 39 und eine variable Strecke 40. Die Vorlaufstrecke 39 grenzt an die Kontaktfläche 29 an und hat für alle Betätiger 27 die gleiche Länge. Die variable Strecke 40 bildet den Abschnitt von der Vorlaufstrecke 39 bis zum Muster 31. Die Vorlaufstrecke 39 ist ein Mindestmass für die Distanz zwischen der Kontaktfläche 29 und dem Muster 31.

Es ist möglich, weitere Betätiger 27 herzustellen, welche jeweils unterschiedliche Distanzen, d.h. variable Strecken 40, zwischen den Musterflächen 33 und der Kontaktfläche 29 aufweisen und entsprechend jeweils eine andere Reflektion der Schallwellen 35 erzeugen, was wiederum zu einem anderen Signal führt.

Die Schallwellen 35 werden durch den Empfänger in ihrer Gesamtheit aufgenommen und als ein analoges Signal weitergeleitet. Das analoge Signal kann im analogen Front-end 21 verarbeitet werden, um den Vergleich zwischen den Signalen zu vereinfachen. Die Amplitude des Signals wird in Abhängigkeit der Messzeit aufgetragen, womit eine zeitliche Funktion des Signals gebildet wird. Die Erkennung eines Betätigers 27 erfolgt mittels des Abgleichs der so erstellten Funktion des Signals. Der Abgleich findet dabei allgemein durch Vergleich des gemessenen Signals 41 mit einem Referenz-Signal 43 statt. Das Referenz-Signal kann auf unterschiedliche Art erzeugt werden.

Eine erste Methode zur Erzeugung des Referenz-Signals 43 ist das Berechnen eines Mittelwertes, wofür jeder Datenpunkt der Messreihe über mehrere Messreihen gemittelt wird. Hierbei kann die Auswahl der Messungen zum Berechnen des Mittelwerts variabel gehalten werden, so dass bei Durchführung von Messungen die erhaltenen Messwerte laufend in die Berechnung des Mittelwertes miteinfliessen. Die Formate des gemessenen Signals 41 und des Referenz-Signals 43 müssen derart übereinstimmen, dass ein Vergleich beider Signale möglich ist. Um dies zu gewährleisten, können die Signale einer digitalen Signalverarbeitung unterzogen werden. Anschliessend kann das Referenz-Signal 43 zum Beispiel mittels einer Korrelation oder einer Kreuz-Korrelation mit einem gemessenen Signal 41 verglichen werden. Durch die Kreuz-Korrelation wird eine Zahl berechnet, die die Verschiebung zwischen den beiden Signal-Funktionen aufzeigt. Falls diese Zahl gegen Null geht, liegt eine Übereinstimmung des Betätigers vor. Um einen binären Output zu generieren, kann für das Ergebnis der Kreuz-Korrelation ein Grenzwert festlegt werden, unterhalb dessen der Betätiger als richtig erkannt gilt. Eine alternative Methode zur Kreuz-Korrelation ist die Verwendung der Methode Mean Square Error, bei welcher die Summe der mittleren quadratischen Abweichung gebildet wird. Je kleiner diese Summe ausfällt, umso ähnlicher sind die miteinander verglichenen Funktionen bzw. Signalverläufe. Zur Erkennung eines Betätigers 27 muss hier ein Grenzwert für die Summe der quadratischen Abweichung definiert werden. Falls das Ergebnis unterhalb dieses Grenzwerts ist, liegt eine Ähnlichkeit vor und der Betätiger wird als positiv erkannt. Üblicherweise liegt das Referenz-Signal als auch das gemessene Signal vor der Durchführung des Abgleichs in normiertem Zustand vor.

Ein alternativer Ansatz zur oben beschriebenen ersten Methode für das Erstellen eines Abgleichs mit einem Referenz-Signal ist der Einsatz von künstlicher Intelligenz. Dabei werden zur Erkennung eines Betätigers Trainingsdaten in ein neuronales Netzwerk eingelesen. Diese Trainingsdaten müssen zuerst erzeugt werden. Dazu wird die Anzahl aller unterschiedlichen Betätiger 27 produziert,, welche durch den Sensor 13 eingelesen werden und deren Signal in einer Datenbank abgelegt wird. Die Messung der eingelesenen Betätiger 27 durch den Sensor 13 kann unter unterschiedlichen Randbedingungen stattfinden, so dass zum Beispiel der Einfluss der Kontaktfläche 29 und des Kontaktes zwischen dem Sensor 13 und dem Betätiger 27 in den Trainingsdaten enthalten sein kann. Die Daten sind in mehrere Klassen eingeteilt, wobei die Anzahl an Klassen gleich der Anzahl an unterschiedlichen Betätigern plus eins ist. Die zusätzliche Klasse ist eine Klasse, in welche jedes Signal zugewiesen wird, das nicht in eine der Betätiger-Klassen passt. Somit wird jedes durch den Sensor aufgenommene Signal einer Klasse zugeordnet. Für die Zuordnung der empfangenen Signale 41 zur jeweiligen Klasse ist die Recheneinheit 24 zuständig. Die Recheneinheit 24 bedient sich hierfür von einem künstlichen neuronalen Netzwerk oder anderen KI-Methoden, welche mit Trainingsdaten trainiert wurden und einen Klassifizierungsmechanismus entwickelt haben. Die Zuordnung der empfangenen Signale 41 zur jeweiligen Klasse fällt unter das Abgleichen eines empfangenen Signals 41 mit einem Referenz-Signal 43.

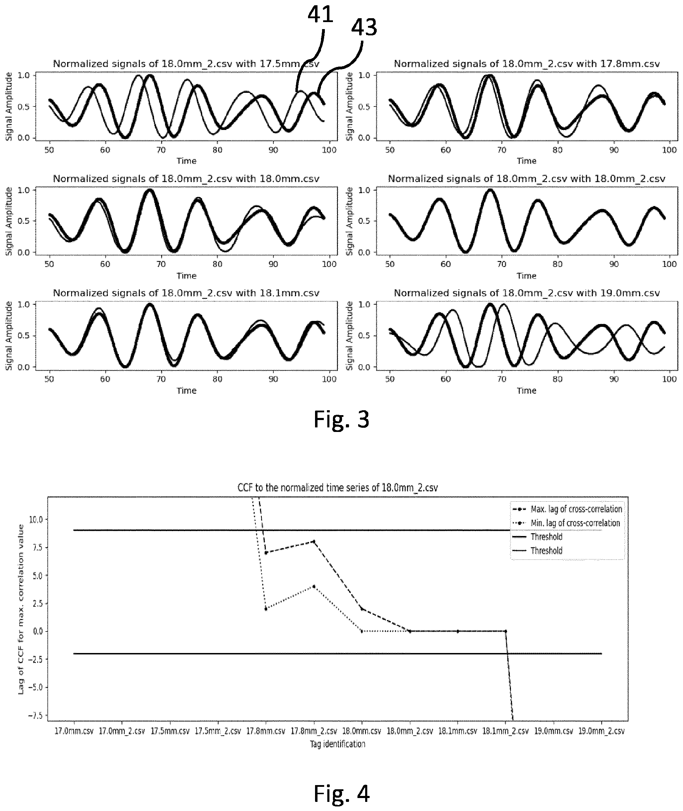

In den Figuren 3 und 4 sind Diagramme gezeigt, mit welchen die oben erwähnte Korrelation gebildet und die Erkennung des Betätigers 27 vorgenommen werden kann. In Figur 3 sind sechs Diagramme abgebildet, in welchen jeweils ein gemessenes Signal 41 eines bestimmten Betätigers mit einem Referenz-Signal 43 zusammen aufgetragen ist. Dabei ist das Referenz-Signal 43 durch eine dicke Linie gezeigt, während das gemessene Signal 41 jeweils durch eine dünne Linie gebildet ist. Das Referenz-Signal 43 ist in diesem Beispiel mit einem Betätiger 27 mit einer einzigen Codiertiefe von 18 mm gebildet. Die sechs Diagramme zeigen die vom Empfänger 19 aufgenommene und zur Recheneinheit 24 weitergeleitete reflektierte Schallwellen in normiertem Zustand für Betätiger 27 mit einer Codiertiefe von 17.5 mm, 17.8 mm, 18 mm, 18.1 mm und 19 mm. Für die Codiertiefe von 18 mm sind zwei Messreihen getestet worden. In Figur 4 ist der maximale und minimale Korrelationswert zwischen dem Mess-Signal 41 und dem Referenz-Signal 43 für die unterschiedlichen Betätiger 27 aufgetragen. Auf der X-Achse des Diagramms in Figur 4 sind die Betätiger 27 mit aufsteigender Codiertiefe aufgetragen, während die Y-Achse den Korrelationswert angibt. Für den Korrelationswert ist ein oberer und ein unterer Grenzwert definiert, welche im Diagramm durch zwei horizontale Linien abgebildet sind. Die Ergebnisse in Figur 4 zeigen, dass die Korrelation für jene Betätiger innerhalb der Grenzwerte liegt, welche eine Codiertiefe von 17.8 mm bis 18.1 mm aufweisen. Im Vergleich dazu ist das Referenz-Signal 43 mit einem Betätiger 27 mit einer Codiertiefe von 18 mm gebildet.

Eine weitere mögliche Methode in dieser oder ähnlicher Ausführung zum Abgleichen des Mess-Signals 41 mit einem Referenz-Signal 43 ist das Bilden des Differenzsignal zwischen diesen beiden Signalen. Im Gegensatz zum vorherigen Ansatz, in welchem eine Zuordnung von mehreren Betätigern zu verschiedenen Klassen vorgenommen wurde, wird durch Bilden des Differenzsignals oder anderer Methoden eine binäre Klassifizierung angestrebt. Das heisst, dass als Ergebnis eine binäre Aussage getätigt wird, ob das Mess-Signal 41 eine ausreichende Übereinstimmung mit dem Referenz-Signal 43 aufweist oder nicht. Bei vollständiger Übereinstimmung ist das Mess-Signal 41 gleich dem Referenz-Signal 43 und die Differenz beider Signale gleich Null. Bei Beschallung des Referenz-Betätigers, kann die Differenz beider Signale von Null abweichen. Deshalb ist ein Toleranzbereich in Form eines Thresholds für die Differenz definiert, in welchem die Erkennung des Referenz-Betätigers noch als positiv gewertet wird. Die binäre Klassifizierung wird lediglich bei Verwendung zur Erkennung eines einzelnen Betätigers eingesetzt, da damit eine Aussage darüber gemacht werden kann, ob dieser einzelne Betätiger zur Zeit der Messung an jener Stelle ist, an welcher er während der Referenz-Messung war. Bei einer Sicherheitsanwendung kann damit zum Beispiel der Schliesszustand einer Türe kontrolliert werden.

Der Näherungsschalter wird wie folgt betrieben: Schallwellen werden durch die Anregung des Ultraschallwandlers mit zwei Pulsen während einer vorbestimmten ersten Zeitdauer, die je nach Arbeitsfrequenz des Ultraschallwandlers zwischen 0.25 µs und 5 µs liegt, ausgesendet. Danach werden die reflektierten Schallwellen während einer vorbestimmten zweiten Zeitdauer, die zwischen 0 µs und 200 µs liegt, erfasst. Vorzugsweise wird mit der Erfassung der reflektierten Schallwellen erst zwischen 30 µs und 60 µs nach dem Senden begonnen, damit das Ausklingen des Ultraschallwandlers nach der Anregung durch die Steuerpulse nicht in die Messung mit einfliesst. Das aktuelle Messfenster liegt zwischen 55 µs und 95 µs des empfangenen Echos.

Während vorstehend spezifische Ausführungsformen beschrieben wurden, ist es offensichtlich, dass unterschiedliche Kombinationen der aufgezeigten Ausführungsmöglichkeiten angewendet werden können, insoweit sich die Ausführungsmöglichkeiten nicht gegenseitig ausschliessen.

Zusammenfassung: Dargestellt und beschrieben ist eine Vorrichtung und ein Verfahren zur Erkennung eines Betätigers durch Beschallen des Betätigers mit Schallwellen durch einen Sensor. Die Vorrichtung findet insbesondere in Sicherheitsanwendungen Verwendung. Sensor und Betätiger sind relativ zueinander bewegbar. Der Sensor umfasst einen Schallwellensender, einen Schallwellenempfänger und eine Recheneinheit. Der Schallwellensender ist vorgesehen, Schallwellen in Richtung des Betätigers zu senden. Der Schallwellenempfänger wiederum ist ausgelegt, die vom Betätiger reflektierten Schallwellen aufzunehmen und in ein analoges Signal umzuwandeln. Die Recheneinheit wandelt das analoge Signal in ein digitales Signal um und realisiert die Erkennung des Betätigers durch Abgleich mit einem Referenz-Signal.

### BEZUGSZEICHENLISTE:

- 11: Vorrichtung
- 13: Sensor
- 17: Schallwellensender
- 19: Schallwellenempfänger
- 21: Analoges Frontend
- 23: Erster Kanal
- 24: Erste Recheneinheit
- 25: Zweiter Kanal
- 26: Zweite Recheneinheit
- 27: Betätiger
- 28: Gehäuse
- 29: Kontaktfläche
- 31: Muster
- 33: Reflexionsfläche des Musters
- 35: Schallwellen
- 39: Vorlaufstrecke
- 40: Variable Strecke
- 41: Gemessenes Signal
- 43: Referenz-Signal

## Patentansprüche

1. Vorrichtung (11) zur Erkennung eines Betätigers (27) durch Beschallen des Betätigers mit Schallwellen (35) durch einen Sensor (13), insbesondere in einer Sicherheitsanwendung, wobei
- der Sensor (13) und der Betätiger (27) relativ zueinander bewegbar sind,
- der Sensor (13) einen Schallwellensender (17), einen Schallwellenempfänger (19) und eine Recheneinheit (24) umfasst, wobei Schallwellensender (17) und Schallwellenempfänger (19) als ein einziges Bauteil realisiert sein können, und
- der Schallwellensender (17) vorgesehen ist, Schallwellen (35) in Richtung des Betätigers (27) zu senden und der Schallwellenempfänger (19) vorgesehen ist, die vom Betätiger (27) reflektierten Schallwellen aufzunehmen und in ein analoges Signal umzuwandeln
**dadurch gekennzeichnet, dass**
die Recheneinheit (24) das analoge Signal in ein digitales Signal umwandelt und durch Abgleich mit einem Referenz-Signal (43) die Erkennung des Betätigers (27) realisiert.

2. Vorrichtung (11) gemäss Anspruch 1, **dadurch gekennzeichnet, dass** der Betätiger (27) ein Muster (31) aufweist, von welchem die Schallwellen (35) reflektiert und verändert werden.

3. Vorrichtung (11) gemäss Anspruch 1 oder 2, **dadurch gekennzeichnet, dass** der Sensor (13) zwei Recheneinheiten (24,26) umfasst, welche je ein Referenz-Signal (43) aufweisen.

4. Vorrichtung (11) gemäss Anspruch2 oder 3, **dadurch gekennzeichnet, dass** der Betätiger (27) eine Kontaktfläche (29) für den Sensor (13) aufweist, wobei das Muster (31) im Abstand zur Kontaktfläche (29) angeordnet ist.

5. Vorrichtung (11) gemäss einem der Ansprüche 2 bis 4, **dadurch gekennzeichnet, dass** der Betätiger (27) gegenüber dem Sensor (13) derart angeordnet ist, dass bei Kontakt oder der kleinstmöglichen Distanz zwischen dem Sensor (13) und dem Betätiger (27) der Schallwellensender (17) des Sensors (13) auf das Muster (31) des Betätigers (27) gerichtet ist.

6. Vorrichtung (11) gemäss Anspruch 2 bis 5, **dadurch gekennzeichnet, dass** der Schallwellensender (17) und der Schallwellenempfänger (19) zur Erkennung des Betätigers (27) an der Kontaktfläche (29) des Betätigers (27) aufliegen.

7. Vorrichtung (11) gemäss einem der Ansprüche 1 bis6, **dadurch gekennzeichnet, dass** der Schallwellenempfänger (19) die reflektierten Schallwellen in ihrer Gesamtheit aufnimmt.

8. Vorrichtung (11) gemäss einem der Ansprüche 1 bis7, **dadurch gekennzeichnet, dass** das Referenz-Signal (43) in der Recheneinheit (24) abgelegt ist.

9. Vorrichtung (11) gemäss einem der Ansprüche 2 bis 8, **dadurch gekennzeichnet, dass** das Muster (31) des Betätigers (27) eine dreidimensionale Struktur aufweist.

10. Vorrichtung (11) gemäss einem der Ansprüche 4 bis 8, **dadurch gekennzeichnet, dass** das Muster (31) zwei der Kontaktfläche (29) des Betätigers zugewandte Flächen (33) umfasst, welche je eine unterschiedliche Distanz zur Kontaktfläche (29) aufweisen.

11. Vorrichtung (11)gemäss einem der Ansprüche 1 bis 15, **dadurch gekennzeichnet, dass** der Schallwellensender (17) Schallwellen (35) mit einer Frequenz von 300 kHz bis 20 MHz, vorzugsweise zwischen 350 kHz und 8 MHz, und besonders bevorzugt zwischen 1-4 MHz erzeugt.

12. Verfahren zur Erkennung eines Betätigers (27) mit Hilfe von Schallwellen (35), welche durch einen Schallwellensender (17) gesendet und durch einen Schallwellenempfänger (19) aufgenommen werden, umfassend folgende Schritte;
- Senden von Schallwellen (35) auf ein Muster (31) des Betätigers (27),
- Empfangen der durch das Muster (31) des Betätigers (27) reflektierten Schallwellen durch einen Schallwellenempfänger (19),
- Umwandeln der Schallwellen in ein elektrisches Signal (41),
- Abgleich dieses Signals durch eine Recheneinheit (24) mit einem darin abgelegten Referenz-Signal (43),
- Erzeugen eines binären Signals als Ergebnis des Abgleiches durch die Recheneinheit (24) und Bestimmen der Erkennung des Betätigers (27) aufgrund des binären Signals.

13. Verfahren gemäss Anspruch 12, **dadurch gekennzeichnet, dass** in einem ersten Schritt das Referenz-Signal (43) durch Einlernen des Betätigers (27) erzeugt wird.

14. Verfahren gemäss Anspruch 12 oder 13, **dadurch gekennzeichnet, dass** das Verfahren in einer Sicherheitsanwendung eingesetzt wird und bei nicht erfolgreicher Erkennung des Betätigers (27) ein Warnsignal bzw. ein Sicherheitsentzug oder Abschaltsignal erzeugt wird.

15. Verfahren gemäss einem der Ansprüche 12 bis 14, **dadurch gekennzeichnet, dass** der Betätiger (27) eine Kontaktfläche (29) aufweist und der Schallwellensender (17) zur Erkennung des Betätigers (27) vorzugsweise an dieser Kontaktfläche (29) anliegt, wobei der Schallwellensender (17) im Wesentlichen senkrecht zur Kontaktfläche (29) gerichtete Schallwellen sendet.
